# EUROPEAN PATENT APPLICATION

(11) **EP 4 538 431 A1**
(43) Date of publication of application: **16.04.2025**
(21) Application number: 23819775.0
(22) Date of filing: 02.06.2023
(51) Int. Cl.: C30B 29/30, C30B 15/08

(54) **CRYSTAL MATERIAL, SCINTILLATOR, AND RADIATION DETECTOR**

(30) Priority: 08.06.2022 JP 2022092879
(71) Applicant: Tohoku University, Sendai-shi, Miyagi 980-8577 (JP)
(72) Inventor: YOKOTA Yuui, Sendai-shi, Miyagi 980-8577 (JP); SUDA Takahiro, Sendai-shi, Miyagi 980-8577 (JP); HORIAI Takahiko, Sendai-shi, Miyagi 980-8577 (JP); YOSHINO Masao, Sendai-shi, Miyagi 980-8577 (JP); KAMADA Kei, Sendai-shi, Miyagi 980-8577 (JP); YOSHIKAWA Akira, Sendai-shi, Miyagi 980-8577 (JP)
(74) Representative: Samson & Partner Patentanwälte mbB
(86) International application number: PCT/JP2023/020646
(87) International publication number: WO 2023/238795

(57) **Abstract**

This crystal material is an oxide single crystal represented by the chemical formula M₃(Ta₁₋ₓNbₓ)O₃ ··· (1), having a cubic crystal structure and a density of 8.0 g/cm³ or more. Here, M in the chemical formula is at least one element selected from rare earth elements, and 0 ≤ x ≤ 1 is satisfied. The crystal material is a high-melting-point material having a melting point of 2000°C or more. A radiation detector (100) can be formed of a scintillator (101) formed of the crystal material and a photodetector (102) that receives scintillation light from the scintillator (101).

## Description

### Technical Field

The present invention relates to a crystal material, a scintillator, and a radiation detector.

### Background Art

Measurement of γ-rays, X-rays, α-rays, β-rays, neutron rays and the like is an important technique. A scintillator is used for this type of measurement. In particular, a scintillator crystal body having a high density has characteristics such as a) having a high radiation stopping power when irradiated with radiation typified by γ-rays, b) having a large effective atomic number, and c) having a large density. A scintillator material having a high density is expected to be used as a scintillator material in a Cherenkov detector or a radiation detector for cosmic rays.

Further, in a radiation detector used in a medical device, a scintillator material having the above-described characteristics can realize high detection performance due to high radiation stopping power, and effects such as shortening of measurement time and reduction of radiation irradiation time can be expected. Here, when a material is used as a scintillator material, the material preferably has a higher light emission amount and a higher energy resolution, and for this reason, the scintillator material is preferably used as a transparent single crystal with no impurities.

A scintillator material having a particularly large density or effective atomic number is used for detecting high-energy radiation, and is mounted on a detector for cosmic ray measurement or a high-energy experiment using an accelerator. At present, PbWO₄ single crystal (density: 8.28 g/cm³) having the highest density among the existing scintillator materials is widely used (Non-Patent Documents 1 and 2).

### Citation List

### Non-Patent Document

Non-Patent Document 1: Michiko Morooka, et al., "Tests for radiation damage and recovery of a heavy scintillator, lead tungstate crystal (PbWO4)", Memoirs of the Faculty of Engineering, University of Miyazaki, No. 28, pp. 297 to 301, 1999.
Non-Patent Document 2: Masaaki Kobayashi, "Recent State of Development of Inorganic Crystal Scintillators", Japan Association of High Energy Physicists, High Energy News Research Introduction, Vol. 21, No. 2, pp. 41-50, 2002, [searched on April 20, 2022] (http://www.jahep.org/hepnews/2002/Vol21No2-2002.6.7kobayashi.pdf).

### Summary of Invention

### Technical Problem

However, as the energy of the accelerator and the beam intensity increase, further densification of the scintillator material is required. In addition, since PbWO₄ contains Pb, which is an environmental load substance, at a high concentration, a new lead-free high-density scintillator is required.

The present invention has been made to solve the above problems, and an object of the present invention is to provide a lead-free crystal material having a higher density that can be used as a scintillator material.

### Solution to Problem

A crystal material according to the present invention is an oxide single crystal represented by a chemical formula M₃(Ta₁₋ₓNbₓ)O₃ ··· (1), the oxide single crystal having a cubic crystal structure and a density of 8.0 g/cm³ or more, wherein M in the chemical formula is at least one element selected from rare earth elements, and 0 ≤ x ≤ 1 is satisfied.

In one configuration example of the crystal material, a rare earth element serving as a luminescent center is further added.

A scintillator according to the present invention includes the crystal material.

A radiation detector according to the present invention includes a scintillator including the crystal material and a photodetector that receives scintillation light from the scintillator.

### Advantageous Effects of Invention

As described above, the present invention, in which a single crystal having a density of M₃(Ta₁₋ₓNbₓ)O₃ of at least one element M selected from rare earth elements of 8.0 g/cm³ or more is used, can provide a lead-free crystal material having a higher density that can be used as a scintillator material.

### Brief Description of Drawings

FIG. 1 is a configuration diagram illustrating a configuration of a radiation detector 100 according to an embodiment of the present invention.

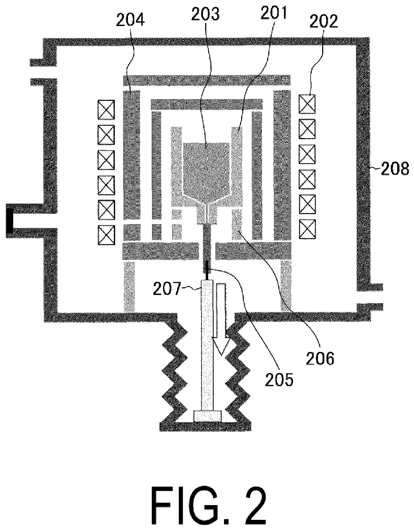

FIG. 2 is a configuration diagram illustrating a configuration of a micro-pulling-down furnace.
FIG. 3 includes photographs of Sample 1 of Example 1.
FIG. 4 is a photograph showing structure observation of Sample 1 of Example 1 with a scanning electron microscope.
FIG. 5A is a characteristic diagram illustrating a result of phase identification on Sample 1 of Example 1 through X-ray diffraction (XRD) measurement.
FIG. 5B is a photograph showing a result obtained by measuring a Laue image of a cut and polished Sample 1 of Example 1 with a back-reflection Laue camera.
FIG. 6 is a characteristic diagram illustrating a result of an emission spectrum measurement on each sample produced in examples.
FIG. 7 is a photograph of Sample 2 of Example 2.
FIG. 8 is a photograph of Sample 3 of Example 3.
FIG. 9 is a characteristic diagram illustrating a result of transmission spectrum measurement on Sample 1.
FIG. 10 is a characteristic diagram illustrating a result of X-ray radioluminescence measurement on Sample 2.
FIG. 11A is a photograph of a sample of Lu₃TaO₇ doped with 1 mol% of Tb at the Lu site.
FIG. 11B is a photograph of a sample of Lu₃TaO₇ doped with 1 mol% of Tm at the Lu site.
FIG. 12A is a characteristic diagram illustrating a result of XRD measurement on the sample of Lu₃TaO₇ doped with 1 mol% of Tb at the Lu site.
FIG. 12B is a characteristic diagram illustrating a result of XRD measurement on the sample of Lu₃TaO₇ doped with 1 mol% of Tm at the Lu site.
FIG. 13A is a characteristic diagram illustrating a result of X-ray radioluminescence measurement on the sample of Lu₃TaO₇ doped with 1 mol% of Tb at the Lu site.
FIG. 13B is a characteristic diagram illustrating a result of X-ray radioluminescence measurement on the sample of Lu₃TaO₇ doped with 1 mol% of Tm at the Lu site.

### Description of Embodiment

Hereinafter, a crystal material according to an embodiment of the present invention will be described. The crystal material is an oxide single crystal represented by the chemical formula M₃(Ta₁₋ₓNbₓ)O₃ ··· (1), having a cubic crystal structure and a density of 8.0 g/cm³ or more. Here, M in the chemical formula is at least one element selected from rare earth elements, and 0 ≤ x ≤ 1 is satisfied. The crystal material is a high-melting-point material having a melting point of 2000°C or more. For example, M in the chemical formula may be at least one element of Lu, Gd, and La.

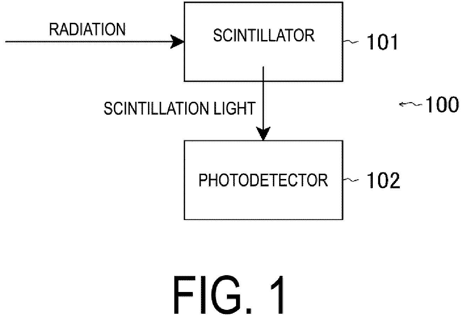

The crystal material according to the above-described embodiment can be used as a scintillator material. The radiation detector 100 can be formed of a scintillator 101 configured from the crystal material according to the embodiment and a photodetector 102 that receives scintillation light from the scintillator 101 (FIG. 1). The crystal material according to the embodiment has a high radiation stopping performance and a high refractive index. The crystal material according to the embodiment can be formed into any thickness depending on a crystal growth method.

For example, to obtain a single crystal of a crystal material represented by the chemical formula Lu₃TaO₇, Lu₂O₃ and Ta₂O₅ are used as raw materials, and the ratio thereof can be set to Lu₂O₃ : Ta₂O₅ = 75 : 25. The melting point of Lu₃TaO₇ is about 2400°C (Reference Document 1). For example, to obtain a single crystal of a crystal material represented by the chemical formula Lu₃NbO₇, Lu₂O₃ and Nb₂O₅ are used as raw materials, and the ratio thereof can be set to Lu₂O₃ : Nb₂O₅ = 75 : 25. The melting point of Lu₃NbO₇ is about 2030°C (Reference Document 2).

It is preferable to form a single crystal with the above compositions to obtain a good single crystal. These compositions correspond to congruent compositions. However, it does not mean that the composition should not deviate from the above composition at all, and a deviation in the range of ±5 mol% with respect to the congruent composition can be allowed. The deviation can be allowed, more preferably, in the range of ±2 mol%. The reason for limiting the range in the vicinity of these compositions is that a single crystal having a solid solution region can be obtained when each composition is in the vicinity of the congruent composition in single crystal growth, and in the other composition range, that is, when a deviation of 5 mol% or more is made, one phase is crystallized first, which becomes a factor for disturbing the single crystal structure.

However, there is also a measurement error in the eutectic composition exemplified above. Thus, it is important that the deviation is ±2 mol% from the congruent composition as a concept, but a deviation of about ±5 mol% is allowed as long as a substantially good structure is obtained. Similarly, the above-described melting point means the vicinity of the above-described temperature because of a measurement error or the like, not making any limitation in the melting point.

The crystal material according to the embodiment emits light through radiation excitation. In particular, to increase the light emission efficiency, it is also possible to add a component (rare earth element) serving as a luminescent center to the base material constituting the crystal body or perform an oxidation/reduction treatment.

A lot of additive elements for controlling the emission characteristics can be selected depending on the application and the like, and a single or a plurality of elements can be added. The additive element can be selected from rare earth elements such as La, Ce, Pr, Nd, Sm, Eu, Gd, Tb, Dy, Ho, Er, Tm, Yb, and Lu. When the above-described elements are added, they can be appropriately selected depending on the requirements of application such as the light emission amount, the light emission wavelength, the fluorescence lifetime, and the energy resolution. The amount of each additive element to be added can be appropriately selected depending on the application.

The rare earth element M and the additive element for controlling the emission characteristics in the chemical formula M₃(Ta₁₋ₓNbₓ)O₃ have different effects, and therefore can be independently selected in accordance with requirements. Selecting the rare earth element M makes it possible to control the band structure of M₃(Ta₁₋ₓNbₓ)O₃, which is the base material, and to realize efficient energy transfer from the base material to the additive element at the time of radiation excitation. On the other hand, the additive element for controlling the light emission characteristics can control the wavelength, fluorescence lifetime, light emission amount, and the like of light emission generated through radiation excitation.

The Ta site can be doped with Nb depending on the application or the like, and the doping amount of Nb can also be appropriately selected depending on the application. All of Ta may be replaced by Nb.

When this type of crystal material is used as a scintillator material, the crystal material preferably has a higher light emission amount and a higher energy resolution, and for this reason, the material is preferably used as a transparent single crystal with no impurities. The performance of the scintillator largely depends on the stopping power of radiation. The radiation stopping power is a value determined by the density and the effective atomic number, and in general, the radiation stopping power is improved by increasing the density and the effective atomic number.

For example, a rare earth tantalate represented by the chemical formula RE₃TaO₇ (RE is a rare earth element) is a material system having a large density and a large effective atomic number, and therefore attracts attention as a scintillator having a high radiation stopping power. Many scintillators need to extract light generated through radiation irradiation to the outside, and to efficiently extract light without attenuation, they are used as single crystals that are transparent at the emission wavelength of light.

However, RE₃TaO₇ has a melting point exceeding 2200°C. Thus, in the single crystal growth by the melt growth technique using a known noble metal crucible, the temperature for crystal growth exceeds the use temperature of platinum or iridium constituting the crucible, and thus the single crystal of RE₃TaO₇ cannot be grown (crystal growth).

On the other hand, the single crystal growth of a material system having a melting point exceeding 2200°C has been attempted by a melt growth method using a molybdenum crucible, a tungsten crucible, or a rhenium crucible. However, since molybdenum, tungsten, and rhenium, which are crucible materials, are more easily oxidized than platinum and iridium, it is necessary to bring the growth atmosphere into a reducing state, and growth has been performed in an atmosphere in which 2% or more of hydrogen is mixed with argon. In the case of crystal growth in a reducing atmosphere, the crucible may be damaged, the melt of the material to be grown may react with the crucible during crystal growth, the crucible material may be mixed into the crystal, or the raw material may be decomposed in the reducing atmosphere. Thus, the crystal growth has been used only in very limited systems such as sesquioxide systems and sapphire single crystals.

Further, the price of rhenium crucible has been raised several times to ten and several times higher than the crucible made of platinum or iridium because of the recent rise in the price of rhenium. Thus, the rhenium crucible cannot be selected as a method for producing a commercial single crystal.

As a technique for solving the problem described above, there is crystal growth by using a tungsten crucible together with a deoxidized zirconia heat insulating material in an inert atmosphere and unidirectionally solidifying a raw material melt contained in the tungsten crucible. A single crystal of RE₃TaO₇ having a high melting point can be grown through the crystal growth performed in an inert atmosphere together with the tungsten crucible and the deoxidized heat insulating material.

This crystal growth method includes a first step of mixing materials constituting a single crystal having a high melting point such as RE₃TaO₇, a second step of deoxidizing a heat insulating material in a carbon furnace under a high-temperature inert atmosphere, a third step of melting the material constituting the single crystal having a high melting point filled in a tungsten crucible using the deoxidized heat insulating material, and a fourth step of solidifying the molten material having a high melting point along one direction to form a single crystal.

Performing crystal growth in this manner can produce a scintillator crystal body having a high melting point of 2100°C or more and a high density. In this crystal growth method, it is possible to grow a crystal without deteriorating the tungsten crucible and while suppressing the reaction between the molten raw material and the crucible by using the deoxidized heat insulating material. Thus, it is possible to grow the crystal in a temperature zone exceeding 2100°C, which has not been possible in the crystal growth using the known platinum crucible or iridium crucible.

Next, a method for producing a crystal material (crystal growth method) according to the above-described embodiment will be described.

First, in the first step, materials constituting the crystal phase are mixed to obtain a raw material body. Next, in the second step, the produced raw material body is melted. The melting of the raw material body can be performed using a predetermined crucible, for example. Next, in the third step, the molten raw material is solidified along one direction to produce a crystal body (crystal material).

The method for producing a crystal material can be performed by any method (crystal growth method) as long as it is a method for melting and solidifying a desired material system at an optimum composition with unidirectionality. In particular, it is required to control the temperature gradient so as to realize stable crystal growth, and the temperature gradient at the solid-liquid interface of the mixture is preferably 10°C/mm or more. However, to eliminate cracks and the like due to thermal stress on the crystal, the temperature gradient can be lowered within a range that does not cause any problem. Cracks and the like can also be suppressed by reheating a portion that has already become a crystal body to such an extent that the portion does not melt.

Next, an apparatus (micro-pulling-down furnace) for producing the crystal material (crystal growth) according to the embodiment will be described with reference to FIG. 1. The micro-pulling-down method is suitable for crystal growth of a crystal material having a high melting point because a solid-liquid interface can be formed immediately below the bottom of a crucible 201 by placing a raw material body 203 in the crucible 201 having a hole at the bottom, heating the crucible 201 by high-frequency induction heating using a high-frequency induction coil 202, and then pulling down the melt of the molten raw material body 203 from the bottom of the crucible 201 using a seed crystal or the like. The crucible 201 may be formed of tungsten.

This apparatus includes the high-frequency induction coil 202 having a length matching the length of the crucible 201, and a heat insulating material 204 for realizing a temperature gradient of 10°C/mm or more at the solid-liquid interface of the raw material body 203 which is a mixture. The melt at the bottom of the crucible 201 is pulled down by a seed rod 205 made of tungsten disposed below the crucible 201, whereby solidification is performed in one direction. Not only the seed rod 205 but also a seed crystal can be used. The seed rod 205 is fixed to an upper end of a rod 207, and the seed rod 205 can be pulled down by pulling down the rod 207 with a pull-down mechanism (not illustrated).

In addition, the temperature gradient at the solid-liquid interface can be controlled to an optimum value for crystal production by an after heater 206 provided at the lower portion of the crucible 201. A production method using an equivalent mechanism is also possible. The temperature gradient can be less than 10°C/mm as long as the solid-liquid interface can be made smooth. The crucible 201, the high-frequency induction coil 202, the heat insulating material 204, the seed rod 205, and the after heater 206 are disposed in a chamber 208.

The crystal material can also be produced by crystal pulling as in the Czochralski method. In this case, the crystal is not pulled down in the downward direction as in the micro-pulling-down method, and thus it is more preferable in that a large crystal body can be produced. Further, crystal production in a crucible as in the Bridgman method is also possible. This case is more preferable in that a large crystal body can be produced at a high yield by optimizing the production conditions. Further, the crystal material can be produced in the same manner by a floating zone method. This case is more preferable in that it is not necessary to use a crucible, impurities are not mixed from the crucible, and the cost of the crucible is not needed. Further, crystal pulling using a die, such as the EFG (Edge-defined Film-fed Growth) method, can also be used for producing the crystal material. This case is more preferable in that the shape of the sample to be produced can be controlled.

Next, the charging composition of the raw material of the crystal body to be produced will be described. For the charging composition of the raw material body to form the crystal material according to the above-described embodiment, a deviation of ± 5 mol% or more is allowed. That is, in the case of the micro-pulling-down method, when the raw material is solidified in one direction in the downward direction of the crucible from the state where the entire raw material is melted, the material having the target composition is crystallized first from the beginning of solidification, and the composition of the remaining melt gradually changes. As a result, the composition of the melt of the raw material body reaches the eutectic point in the latter half or at the end of solidification, and a phase having a composition different from the target composition is phase-separated and precipitated together with the target composition. The unnecessary portion thus precipitated may be separated after the crystal body is formed.

The crystal material according to the embodiment can be used as a radiation detector utilized in environmental measurement, medical equipment, or the like by being combined with a high electron multiplier tube, a multi-pixel photon counter (MPPC), or the like, which is an element performing photoelectric conversion. In particular, since a scintillator formed of the crystal material according to the embodiment has a high density, the scintillator can be applied to a situation in which detection of radiation with higher energy, measurement in a short time, and use of Cherenkov light with a high refractive index are required.

In addition, since there is no need for steps such as conversion of raw materials used in the production of the crystal material into a nano-scale and uniformization of particle sizes, the crystal material can be produced at a lower cost than known transparent ceramic materials, and since there is no decrease in transmittance associated with an increase in size, which is a problem with transparent ceramics, the crystal material is preferably applied to situations where a reduction in cost and an increase in size are required. In the above-described applications, adjustment can be made by adding other materials or controlling the amount of addition so as to meet the required characteristics.

Hereinafter, the present invention will be described in more detail with reference to examples.

### Example 1

First, Example 1 will be described. First, raw material powders of Lu₂O₃ and Ta₂O₅ were weighed at a molar ratio of Lu₂O₃ : Ta₂O₅ = 3 : 1 and mixed using an agate mortar to prepare a powder. The prepared mixed powder was sintered a plurality of times using an alumina crucible in an electric furnace under a temperature condition of 1200°C, whereby a sintered body (raw material body) of Lu₃TaO₇ was obtained. The obtained raw material body was placed in the crucible 201 made of tungsten used for crystal growth. The crucible 201 used had a ϕ3 mm die at the bottom and a 0.5 mm capillary at the center of the die.

Next, the crucible 201 containing the raw material body was placed above the after heater 206 and heated to a temperature of 2400°C or more by operating the high-frequency induction coil 202. The raw material body contained in the crucible 201 was thus completely melted. Thereafter, the melt of the raw material body (raw material melt) contained in the crucible 201 appeared on the bottom surface of the die of the crucible 201 through the capillary at the bottom portion, and the melt spread in a wet state. The wet-spread raw material melt in this manner was brought into contact with the seed rod 205, and the raw material melt was pulled downward together with the seed rod 205, whereby the raw material melt was unidirectionally solidified while forming a solid-liquid interface immediately below the bottom surface of the crucible 201. The rate of pulling down the raw material melt was about from 0.1 to 5 mm/min.

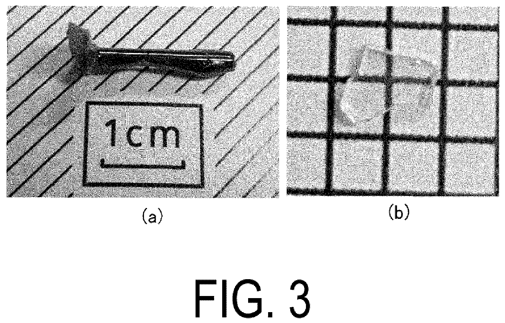

In this manner, the raw material melt was solidified immediately below crucible 201 along one direction, whereby a rod-shaped crystal body (crystal material) was produced. The obtained crystal which is Sample 1 of Example 1 is shown in (a) of FIG. 3. Sample 1 for physical property evaluation obtained by cutting Sample 1 in a direction perpendicular to the growth direction and optically polishing the cut surface was shown in (b) of FIG. 3.

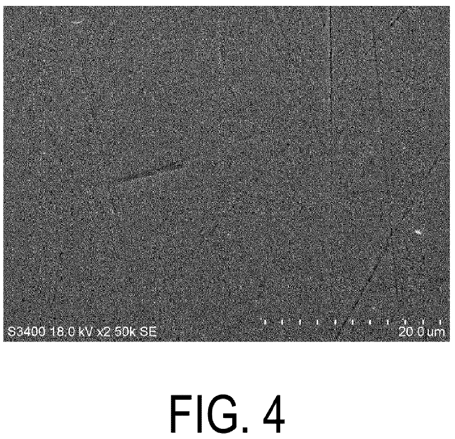

The polished surface of Sample 1 thus produced was subjected to structural observation and composition analysis in a local region using a scanning electron microscope (SEM) and an energy dispersive X-ray spectroscopy (EDX). As a result, the obtained crystal body of Sample 1 was composed of a single phase containing only La, Ta, and O, and the presence of other phases was not confirmed. In addition, as shown in FIG. 4, the presence of grain boundaries was not confirmed in the structure observation with a scanning electron microscope.

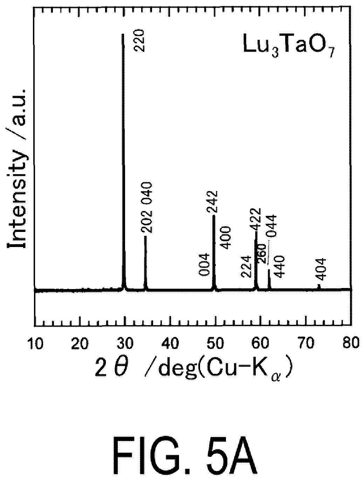

In addition, as a result of phase identification on the produced Sample 1 of Example 1 by X-ray diffraction (XRD) measurement, as shown in FIG. 5A, all diffraction peaks were identified in the cubic crystal system of the space group of Lu₃TaO₇, and no impurity phase was confirmed. These results showed that the crystal body produced in Example 1 was a single phase of Lu₃TaO₇.

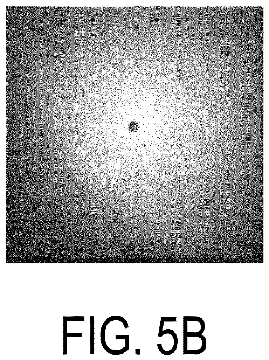

As a result of measuring a Laue image of the cut and polished Sample 1 with a back-reflection Laue camera, a clear Laue spot was confirmed as shown in FIG. 5B. In addition, by this measurement, the pattern of the confirmed Laue spot was able to be identified in the cubic system of the space group, indicating that the produced crystal body of Lu₃TaO₇ was a single crystal.

### Example 2

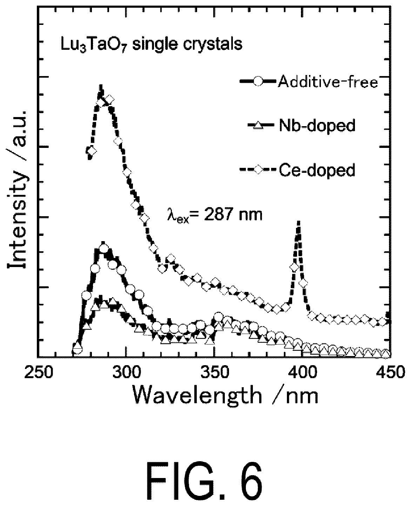

Next, Example 2 will be described. Example 2 shows the effect of light emission characteristic control through Nb substitution at the Ta site on Lu₃TaO₇ produced in Example 1. First, Sample 1 free of additive elements produced in Example 1 exhibited strong sharp light emission in the vicinity of 290 nm and weak broad light emission in the vicinity of 360 nm in the emission spectrum measurement, as indicated by white circles (additive-free) in FIG. 6.

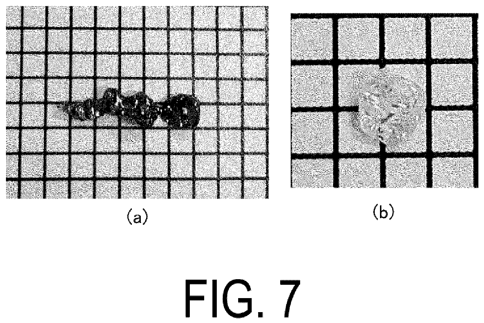

Next, Sample 2 of a crystal body of Lu₃(Ta_{0.9}Nb_{0.1})O₇ in which the Ta site in Lu₃TaO₇ was substituted with 10 mol% of Nb was produced by the same production method as in Example 1 (FIG. 7). Sample 2 of Example 2 was subjected to phase analysis by XRD measurement in the same manner as described above. As a result, Sample 2 had a single phase as in Sample 1 free of additive elements, and from composition analysis using EDX, Sample 2 was composed of a single phase containing only La, Ta, Nb, and O.

In addition, as a result of measuring the Laue image of Sample 2 with a back-reflection Laue camera, a clear Laue spot was able to be confirmed, and the pattern was able to be identified in the orientation of the cubic system, indicating that Sample 2, which was the produced Nb-substituted Lu₃TaO₇ crystal body, was a single crystal. Here, the substitution amount of the additional element is not limited to 10 mol%.

When the photoluminescence measurement was performed on Sample 2 of Lu₃(Ta_{0.9}Nb_{0.1})O₇ doped (substituted) with 10 mol% of Nb at the Ta site, a clear emission peak was made in the vicinity of 290 nm as in Sample 1 free of additive elements (white triangle in FIG. 6). Thus, it was shown that emission at 290 nm was maintained even when Nb was actually substituted.

### Example 3

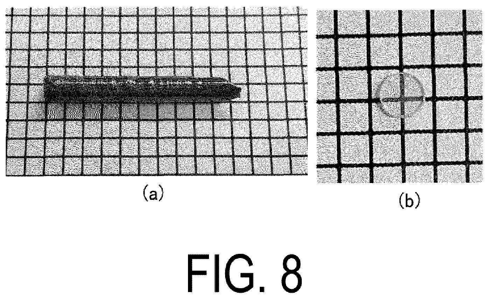

Next, Example 3 will be described. In Example 3, Sample 3 was produced by further doping 0.5 mol% of Ce at the Lu site of Lu₃TaO₇ by the same preparation method as described above. As a result, the crystal body shown in FIG. 8 was able to be obtained, and it was found by XRD measurement, composition analysis by EDX, and Laue image measurement that the crystal body was a single crystal having the same crystal structure as that of the additive-free Lu₃TaO₇ (Sample 1).

When the photoluminescence measurement was performed on the Ce-doped Lu₃TaO₇ of Sample 3, a clear emission peak was made in the vicinity of 290 nm (white squares in FIG. 6) as in Sample 1 free of additive elements. This indicates that 290 nm emission is maintained even when Ce is actually doped.

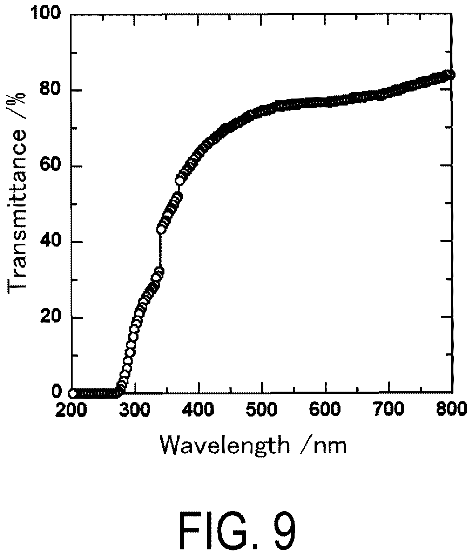

As a result of transmission spectrum measurement on Sample 1 of the obtained Lu₃TaO₇ single crystal, as shown in FIG. 9, transmittance of 70% or more was exhibited in a wavelength region of 450 nm or more, exhibiting high transmittance equivalent to that of other optical crystals. This high transmittance was also exhibited in the crystals (Sample 2 and Sample 3) obtained through Nb substitution or Ce doping.

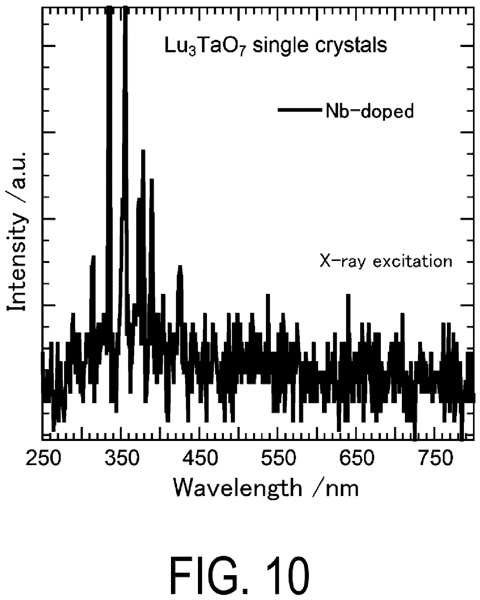

When the Nb-substituted Lu₃TaO₇ single crystal (Sample 2) was subjected to X-ray radioluminescence measurement, light emission was confirmed in the vicinity of 350 nm as shown in FIG. 10, indicating that light emission was caused by radiation irradiation.

### Example 4

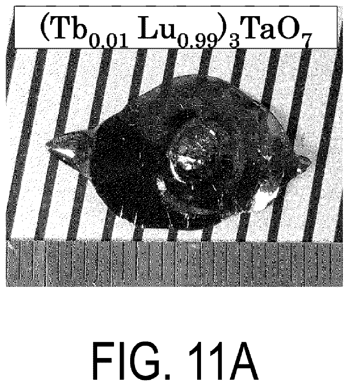

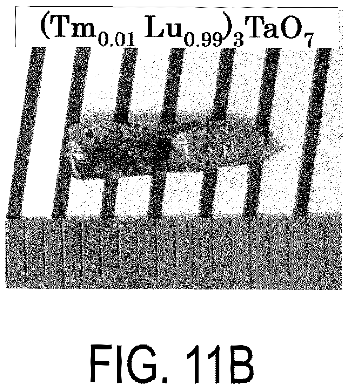

Next, Example 4 will be described. In Example 4, a sample of Lu₃TaO₇ doped with 1 mol% of Tb or Tm at the Lu site was produced by the same production method as described above. As a result, the crystal bodies shown in FIGS. 11A and 11B were able to be obtained. FIG. 11A shows a sample of Lu₃TaO₇ doped with 1 mol% of Tb at the Lu site, and FIG. 11B shows a sample of Lu₃TaO₇ doped with 1 mol% of Tm at the Lu site.

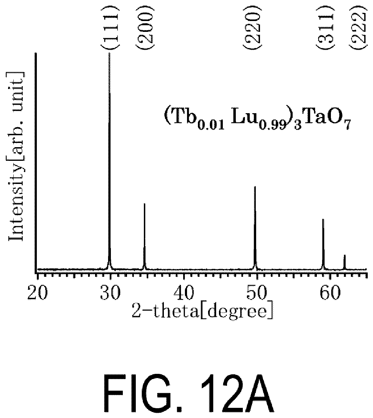

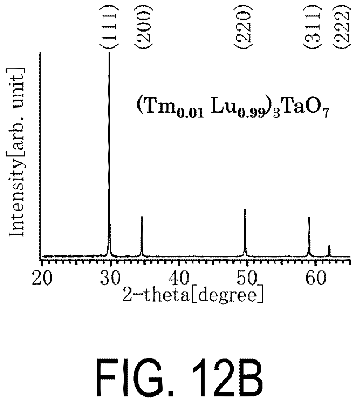

These samples were subjected to XRD measurement, composition analysis by EDX, and Laue image measurement, and as a result, it was found that they were single crystals having the same crystal structure as that of the additive-free Lu₃TaO₇. The result of the XRD measurement on the sample of Lu₃TaO₇ doped with 1 mol% of Tb at the Lu site is shown in FIG. 12A. The result of XRD measurement on the sample of Lu₃TaO₇ doped with 1 mol% of Tm at the Lu site is shown in FIG. 12B.

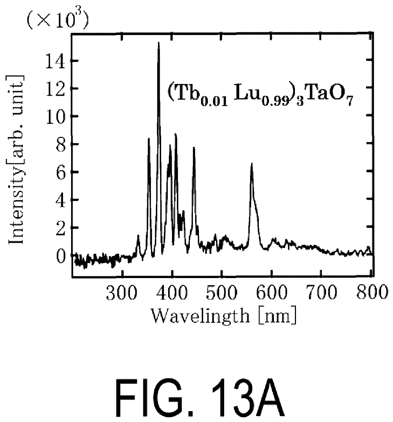

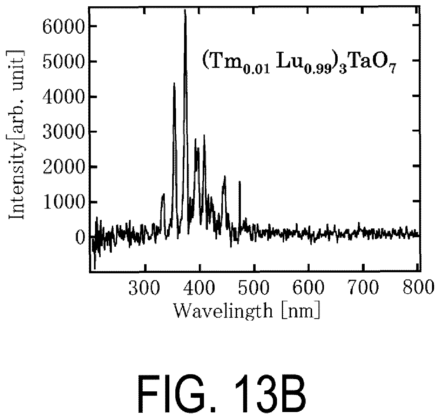

Next, the results of radioluminescence measurement with X-ray for each of the above-described samples are shown in FIGS. 13A and 13B. As shown in FIG. 13A, in the sample of Tb-doped Lu₃TaO₇, an emission peak that was not confirmed in the sample free of additive elements was clearly confirmed in the range of from 500 to 600 nm. From this result, it was found that light emission derived from each additive element was exhibited by changing the additive element.

As described above, the present invention, in which a single crystal having a density of M₃(Ta₁₋ₓNbₓ)O₅ of at least one element M selected from rare earth elements of 8.0 g/cm³ or more is used, can provide a lead-free crystal material having a higher density that can be used as a scintillator material.

It should be noted that the present invention is not limited to the embodiments described above, and it is apparent that many modifications and combinations can be made by those skilled in the art within the technical idea of the present invention.

[Reference Document 1] X. Xing et al., "High-Temperature Phase Relationships in the Lu2O3-Ta2O5 System", Journal of the American Ceramic Society, vol. 99, no. 3, pp. 1042 to 1046, 2016.

[Reference Document 2] L. An et al., "Transparent Lu3NbO7 bodies prepared by reactive spark plasma sintering and their optical and mechanical properties", Ceramics International, vol. 39, pp. 383 to 387, 2013.

### Reference Signs List

100...Radiation detector, 101...Scintillator, 102... Photodetector

## Claims

1. A crystal material that is an oxide single crystal represented by a chemical formula M₃(Ta₁₋ₓNbₓ)O₃, the oxide single crystal having a cubic crystal structure and a density of 8.0 g/cm³ or more,
wherein M in the chemical formula is at least one element selected from rare earth elements, and 0 ≤ x ≤ 1 is satisfied.

2. The crystal material according to claim 1,
wherein a rare earth element serving as a luminescent center is further added.

3. A scintillator comprising the crystal material according to claim 1 or 2.

4. A radiation detector comprising:
a scintillator including the crystal material according to claim 1 or 2; and
a photodetector that receives scintillation light from the scintillator.
